# EUROPEAN PATENT APPLICATION

(11) **EP 4 825 714 A1**
(43) Date of publication of application: **21.10.2026**
(21) Application number: 25190348.0
(22) Date of filing: 18.07.2025
(51) Int. Cl.: B62J 11/00, F16M 11/04, F16M 11/14, F16M 13/02

(54) **QUICK-RELEASE ELECTRONIC EQUIPMENT HOLDER**

(30) Priority: 18.04.2025 CN 202520734662 U
(71) Applicant: Shenzhen Qianhai Lamiku Information Technology Co., Ltd., Shenzhen, Guangdong (CN)
(72) Inventor: Zhang, Bo, Shenzhen (CN); Li, Lianzeng, Shenzhen (CN); Luo, Shenxiang, Shenzhen (CN)
(74) Representative: Mirlach, Xiaolu

(57) **Abstract**

This application discloses a quick-release electronic equipment holder, and the holder includes a holder body and a support component, where electronic equipment is fixed onto the holder body, and the support component is installed in an external environment scenario; and the quick-release electronic equipment holder further includes an attachment component and a rotating component that are connected in a relatively rotating way, where the attachment component is detachably connected to the holder body and the support component, the attachment component includes an accommodating slot, and the rotating component can be accommodated in the accommodating slot. The quick-release electronic equipment holder provided by this application has the disadvantages of solving a problem that the holder parts of existing holder products are too large and reducing the transportation cost.

## Description

### FIELD OF TECHNOLOGY

This application relates to the field of holders, and in particular, to a quick-release electronic equipment holder.

### BACKGROUND

Most of existing mobile phone holders and tablet holders are of a universal ball head structure fitting with an accommodating slot. For example, in Chinese patent CN2020229789721, a universal ball is connected to a sleeve part. At present, sleeve parts of all holder products are directly provided on the holder, and the sleeve parts and a holder body are integrally formed, resulting in a relatively thick holder part. A relatively high transportation cost occurs due to the limitation of size and thickness, so it is necessary to solve a problem that the holder part is too thick.

### SUMMARY

A purpose of this application is to provide a quick-release electronic equipment holder, which solves a problem that the holder parts of existing holder products are too large and reduces the transportation cost.

A quick-release electronic equipment holder provided according to an embodiment of this application includes a holder body and a support component, where electronic equipment is fixed onto the holder body, and the support component is installed in an external environment scenario; and the quick-release electronic equipment holder further includes an attachment component and a rotating component that are connected in a relatively rotating way, where the attachment component is detachably connected to the holder body and the support component, the attachment component includes an accommodating slot, and the rotating component can be accommodated in the accommodating slot.

Preferably, the rotating component is provided on the support component.

Preferably, the attachment component further includes a connecting element, the connecting element is connected to the accommodating slot, a connecting slot is provided in the holder body, and the connecting element is detachably provided in the connecting slot.

Preferably, the connecting element includes a snap-fit element and an insert, the snap-fit element and the insert are spaced apart, and the snap-fit element extends obliquely outward a side far away from the accommodating slot.

Preferably, two inserts are provided and are symmetrically spaced apart on both sides of the snap-fit element; the bottom of the snap-fit element is provided with a protrusion; a connecting hole is provided in the connecting slot of the holder body; and the protrusion can be accommodated in the connecting hole.

Preferably, a surface of the protrusion facing the direction of the accommodating slot is an inclined surface.

A technical solution provided by the embodiment of this application can include the following beneficial effects: a quick-release electronic equipment holder provided by this application includes a holder body and a support component, where electronic equipment is fixed onto the holder body, and the support component is installed in an external environment scenario; and the quick-release electronic equipment holder further includes an attachment component and a rotating component that are connected in a relatively rotating way, where the attachment component is detachably connected to the holder body and the support component, the attachment component includes an accommodating slot, and the rotating component can be accommodated in the accommodating slot. The attachment component is separated from the holder body, so that the holder body, the support component and the attachment component can be packaged separately in a packaging process, and the attachment component can be placed in a gap between the holder body and the support component due to its small size, thus reducing the overall thickness size of the holder body, further reducing the overall packaging size and the logistics distribution fee and saving costs.

### BRIEF DESCRIPTION OF THE DRAWINGS

In order to more clearly explain the technical solution in embodiments of this application, the accompanying drawings needed in the descriptions of the embodiments will be briefly described below. Apparently, the accompanying drawings in the following descriptions are only some embodiments of this application. Other accompanying drawings also may be obtained by ordinary persons skilled in the art based on these drawings without any creative labor.
FIG. 1 is an exploded schematic diagram of a quick-release electronic equipment holder according to this application;
FIG. 2 is an exploded schematic diagram of a quick-release electronic equipment holder according to this application;
FIG. 3 is a schematic diagram of a three-dimensional structure of an attachment component according to this application;
FIG. 4 is an exploded schematic diagram of a quick-release electronic equipment holder according to this application;
FIG. 5 is a side view of an attachment component according to this application;
FIG. 6 is an exploded schematic diagram of another embodiment of a quick-release electronic equipment holder according to this application; and
FIG. 7 is an exploded schematic diagram of another embodiment of a quick-release electronic equipment holder according to this application.

### Description of symbols:

10. Quick-release electronic equipment holder; 20. holder body; 21. connecting slot; 30. support component; 40. attachment component; 41. accommodating slot; 42. connecting element; 43. snap-fit element; 44. insert; 45. protrusion; 46. connecting hole; 47. connecting slot; 50. rotating component.

### DESCRIPTION OF THE EMBODIMENTS

The technical solution in embodiments of this application will be described clearly and completely with reference to the accompanying drawings of this application. Apparently, the described embodiments are only some embodiments of this application but not all embodiments thereof. All other embodiments, obtained by ordinary persons skilled in the art based on the embodiments of this application without any creative labor, fall within the scope of protection of this application.

It should also be understood that terms used in the specification of this application are merely intended for describing specific embodiments, instead of limiting this application. As used in the specification and appended claims of this application, singular forms of "one", "an/a" and "the" are intended to include plural forms unless other situations are clearly indicated in the context.

It should be further understood that the term "and/or" used in the specification and appended claims of this application refers to any combination and all possible combinations of one or more of the associated listed items, and includes these combinations.

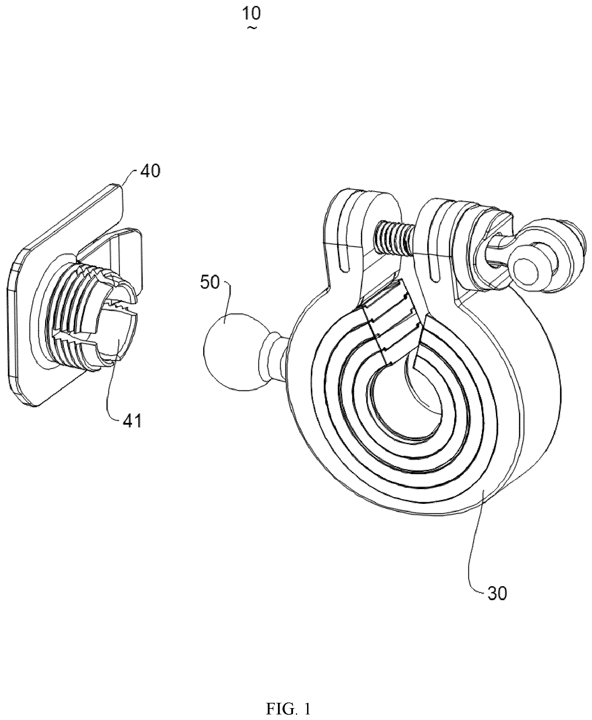

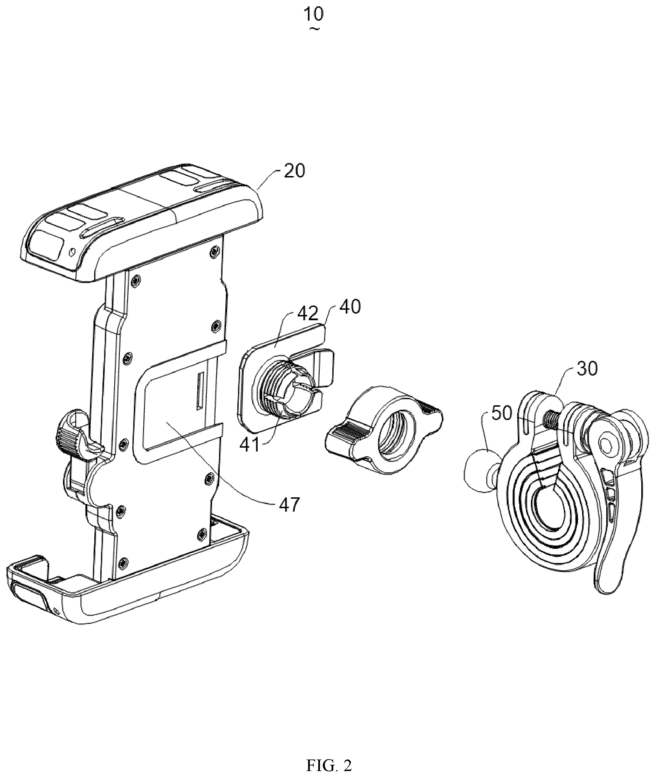

Refer to FIG. 1 and FIG. 2. This application provides a quick-release electronic equipment holder 10, and the quick-release electronic equipment holder includes a holder body 20 and a support component 30, where the holder body 20 is used for fixing electronic equipment such a mobile phone and a tablet personal computer; the support component 30 is installed in an external environment scenario, for example, the support component 30 can be installed on riding vehicles such as bicycles and motorcycles, or the support component 30 can also serve as a base of a desktop stand, a telescopic rod and base of a lazy holder; and the quick-release electronic equipment holder further includes an attachment component 40 and a rotating component 50 that are connected in a relatively rotating way, where the attachment component 40 is detachably connected to the holder body 20 and the support component 30, the attachment component 40 includes an accommodating slot 41, and the rotating component 50 can be accommodated in the accommodating slot 41.

The attachment component 40 is separated from the holder body 20, so that the holder body 20, the support component 30 and the attachment component 40 can be packaged separately in a packaging process, and the attachment component 40 can be placed in a gap between the holder body 20 and the support component 30 due to its small size, thus reducing the overall thickness size of the holder body 20, further reducing the overall packaging size and the logistics distribution fee and saving costs.

In the embodiment, the rotating component 50 is a ball head.

In the embodiment, the rotating component 50 is provided on the support component 30. Alternatively, in some other embodiments, the rotating component 50 can also be connected to an accommodating slot 41 as a separate accessory, and the rotating component 50 can be assembled onto the support component 30.

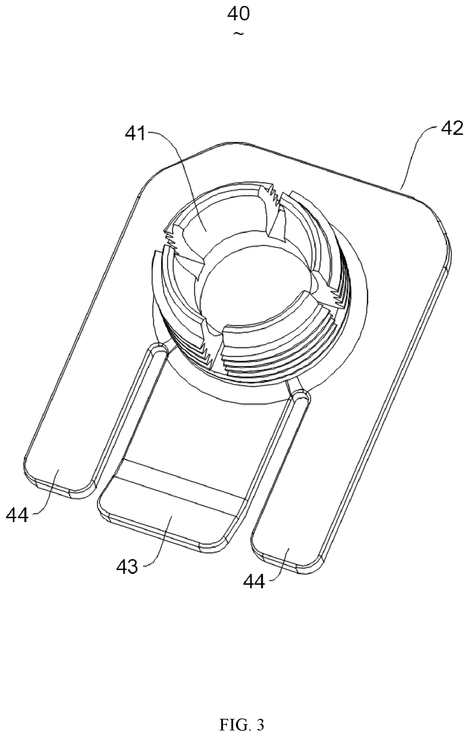

Refer FIG. 2, FIG. 3 and FIG. 4, the attachment component 40 further includes a connecting element 42, the connecting element 42 is connected to the accommodating slot 41, a connecting slot 47 is provided in the holder body 20, and the connecting element 42 is detachably provided in the connecting slot 47. The engagement between the connecting element 42 and the connecting slot 47 facilitates disassembly between the attachment component 40 and the holder body 20. Alternatively, in some other embodiments, the attachment component 40 and the holder body 20 can also be connected by rotating threads. In the embodiment, the connecting slot 47 is a U-shaped slot. Alternatively, in some other embodiments, the connecting slot 47 can be a slot body or an accommodating chamber with other shapes.

The connecting element 42 includes a snap-fit element 43 and an insert 44, the snap-fit element 43 and the insert 44 are spaced apart, and the snap-fit element 43 extends obliquely outward a side far away from the accommodating slot 41. A design that the snap-fit element 43 obliquely extends facilitates deformation thereof when the snap-fit element 43 is engaged with the connecting slot 47, and facilitates removal/insertion of the connecting element 42 from/into the connecting slot 47.

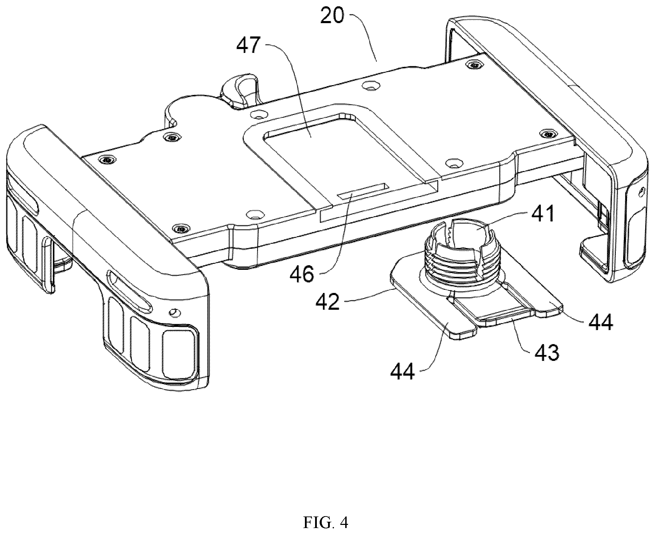

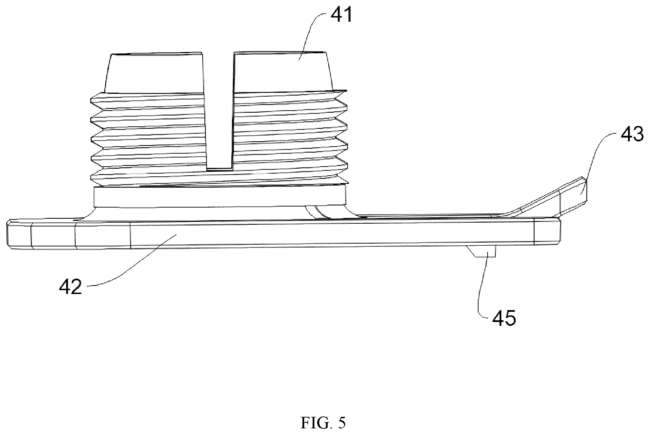

Refer to FIG. 4 and FIG. 5, in the embodiment, two inserts 44 are provided and are symmetrically spaced apart on both sides of the snap-fit element 43; the bottom of the snap-fit element 43 is provided with a protrusion 45; a connecting hole 46 is provided in the connecting slot 47 of the holder body 20; and the protrusion 45 can be accommodated in the connecting hole 46. With the insert 44 and the snap-fit element 43 being spaced apart, there is a gap between the insert 44 and the snap-fit element 43, which enables the snap-fit element 43 to undergo elastic deformation through its own material, facilitating engagement between the protrusion 45 and the connecting hole 46. A surface of the protrusion 45 facing the direction of the accommodating slot 41 is an inclined surface. The protrusion 45 can be accommodated in the connecting hole 46 more smoothly through an inclined plane, and interference between the protrusion 45 and the connecting hole 46 can be avoided.

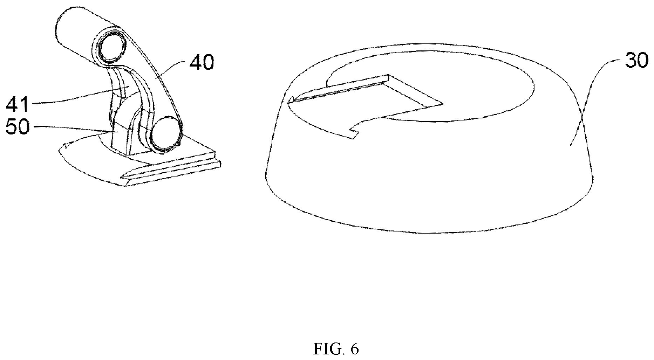

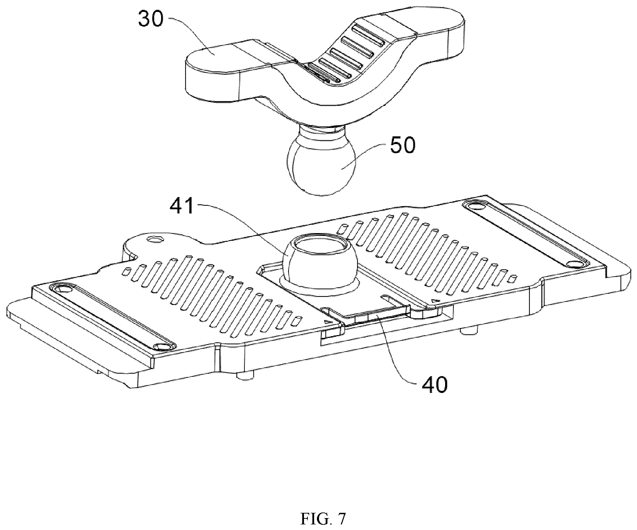

Refer to FIG. 6 and FIG. 7. FIG. 6 and FIG. 7 show other two embodiments in which the rotating component 50 can be accommodated in the accommodating slot 41 and can rotate with respect to the attachment component 40.

A technical solution provided by the embodiment of this application can include the following beneficial effects: a quick-release electronic equipment holder provided by this application includes a holder body and a support component, where electronic equipment is fixed onto the holder body, and the support component is installed in an external environment scenario; and the quick-release electronic equipment holder further includes an attachment component and a rotating component that are connected in a relatively rotating way, where the attachment component is detachably connected to the holder body and the support component, the attachment component includes an accommodating slot, and the rotating component can be accommodated in the accommodating slot. The attachment component is separated from the holder body, so that the holder body, the support component and the attachment component can be packaged separately in a packaging process, and the attachment component can be placed in a gap between the holder body and the support component due to its small size, thus reducing the overall thickness size of the holder body, further reducing the overall packaging size and the logistics distribution fee and saving costs.

The foregoing descriptions are merely the specific embodiments of this application, but the protection scope of this application is not limited to this. Any person skilled in the art, who is familiar with this technical field, can easily think of various equivalent modifications or substitutions within the technical scope disclosed in this application, and these modifications or substitutions should be incorporated in the protection scope of this application. Therefore, the protection scope of this application should be subjected to the protection scope of claims.

## Claims

1. A quick-release electronic equipment holder, including a holder body and a support component, wherein electronic equipment is fixed onto the holder body, and the support component is installed in an external environment scenario; and the quick-release electronic equipment holder further comprising an attachment component and a rotating component that are connected in a relatively rotating way, wherein the attachment component is detachably connected to the holder body and the support component, the attachment component includes an accommodating slot, and the rotating component can be accommodated in the accommodating slot.

2. The quick-release electronic equipment holder according to claim 1, wherein the rotating component is provided on the support component.

3. The quick-release electronic equipment holder according to claim 1, wherein the attachment component further comprises a connecting element, the connecting element is connected to the accommodating slot, a connecting slot is provided in the holder body, and the connecting element is detachably provided in the connecting slot.

4. The quick-release electronic equipment holder according to claim 3, wherein the connecting element comprises a snap-fit element and an insert, the snap-fit element and the insert are spaced apart, and the snap-fit element extends obliquely outward a side far away from the accommodating slot.

5. The quick-release electronic equipment holder according to claim 4, wherein two inserts are provided and are symmetrically spaced apart on both sides of the snap-fit element; the bottom of the snap-fit element is provided with a protrusion; a connecting hole is provided in the connecting slot of the holder body; and the protrusion can be accommodated in the connecting hole.

6. The quick-release electronic equipment holder according to claim 5, wherein a surface of the protrusion facing the direction of the accommodating slot is an inclined surface.
